# FASCICULE DE BREVET EUROPEEN

(11) **EP 4 145 507 B1**
(45) Date de publication et mention de la délivrance du brevet: **31.12.2025**
(21) Numéro de dépôt: 22191493.0
(22) Date de dépôt: 22.08.2022
(51) Int. Cl.: H10K 30/35, H10H 29/01, H10H 29/24, H10H 29/37, H10K 39/32

(54) **PROCÉDÉ DE FABRICATION D'UN DISPOSITIF OPTOÉLECTRONIQUE ET DISPOSITIF OPTOÉLECTRONIQUE**
VERFAHREN ZUR HERSTELLUNG EINER OPTOELEKTRONISCHEN VORRICHTUNG UND OPTOELEKTRONISCHE VORRICHTUNG
METHOD FOR MANUFACTURING AN OPTOELECTRONIC DEVICE AND OPTOELECTRONIC DEVICE

(30) Priorité: 01.09.2021 FR 2109136
(43) Date de publication de la demande: 08.03.2023
(73) Titulaire: Commissariat à l'Energie Atomique et aux Energies Alternatives, 75015 Paris (FR)
(72) Inventeur: TEMPLIER, François, 38054 Grenoble Cedex 09 (FR)
(74) Mandataire: Cabinet Beaumont

(56) Documents cités:
- CN-A- 111 564 465
- DE-A1- 102006 049 120
- US-A1- 2017 186 908
- US-A1- 2018 366 450
- US-A1- 2021 125 971
- US-A1- 2021 366 887

## Description

### Domaine technique

La présente description concerne de façon générale le domaine des dispositifs optoélectroniques, et vise plus particulièrement un procédé de fabrication d'un dispositif optoélectronique combinant une fonction d'émission lumineuse et une fonction de capture optique.

### Technique antérieure

Diverses applications sont susceptibles de tirer profit d'un dispositif optoélectronique combinant une fonction d'émission lumineuse et une fonction de capture optique. Un tel dispositif peut par exemple être utilisé pour réaliser un écran d'affichage interactif.

Le document US 2018/366450 A1 décrit un procédé de fabrication d'une matrice de diodes électroluminescentes sur un fond de panier.

Le document US 2021/125971 A1 décrit une structure d'une matrice de semiconducteurs.

Le document US 2017/186908 A1 décrit un dispositif optoélectronique d'émission de lumière.

### Résumé de l'invention

Un objet d'un mode de réalisation est de pallier tout ou partie des inconvénients des solutions connues pour réaliser un dispositif optoélectronique combinant une fonction d'émission lumineuse et une fonction de capture optique.

L'invention est définie par les revendications 1 et 14. Les revendications dépendantes couvrent des modes de réalisation et variantes de l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I, 1J, 1K, 1L, 1M, 1N, 1O, 1P, 1Q, 1R, 1S et 1T sont des vues schématiques et partielles illustrant des étapes successives d'un exemple d'un procédé de fabrication d'un dispositif optoélectronique selon un mode de réalisation ;
les figures 2A, 2B, 2C, 2D, 2E, 2F, 2G, 2H, 2I, 2J, 2K, 2L, 2M, 2N, 2O, 2P, 2Q, 2R, 2S, 2T, 2U et 2V sont des vues schématiques et partielles illustrant d'autres étapes successives d'un exemple d'un procédé de fabrication d'un dispositif optoélectronique selon un mode de réalisation ; et
les figures 3A, 3B, 3C, 3D, 3E, 3F et 3G sont des vues en coupe, schématiques et partielles, illustrant encore d'autres étapes successives d'un exemple d'un procédé de fabrication d'un dispositif optoélectronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des diodes photosensibles, ou photodétecteurs, des diodes électroluminescentes (LED) et des circuits intégrés de contrôle des dispositifs décrits n'a pas été détaillée, la réalisation détaillée de ces éléments étant à la portée de la personne du métier à partir des indications de la présente description. De plus, les diverses applications pouvant mettre en œuvre les dispositifs décrits n'ont pas détaillées, les modes de réalisation décrits étant compatibles avec toutes ou la plupart des applications susceptibles de tirer profit d'un dispositif combinant une fonction d'émission lumineuse et une fonction de capture optique (photodétection).

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

On désigne par « transmittance d'une couche » le rapport entre l'intensité du rayonnement sortant de la couche et l'intensité du rayonnement entrant dans la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,7 µm.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures correspondantes.

Sauf précision contraire, les expressions "environ", "approximativement", "sensiblement", et "de l'ordre de" signifient à 10 % près, de préférence à 5 % près.

Selon un aspect d'un mode de réalisation, on prévoit, pour réaliser un dispositif optoélectronique combinant une fonction d'émission lumineuse et une fonction de photodétection, un procédé comprenant les étapes de former, sur un circuit intégré de contrôle préalablement formé dans et sur un substrat semiconducteur, une pluralité de diodes électroluminescentes (LED) inorganiques, puis de déposer une couche active semiconductrice de sorte à combler des espaces entre les diodes électroluminescentes. Le procédé comprend en outre des étapes permettant de définir une pluralité de diodes photosensibles, ou photodétecteurs, dans la couche active semiconductrice.

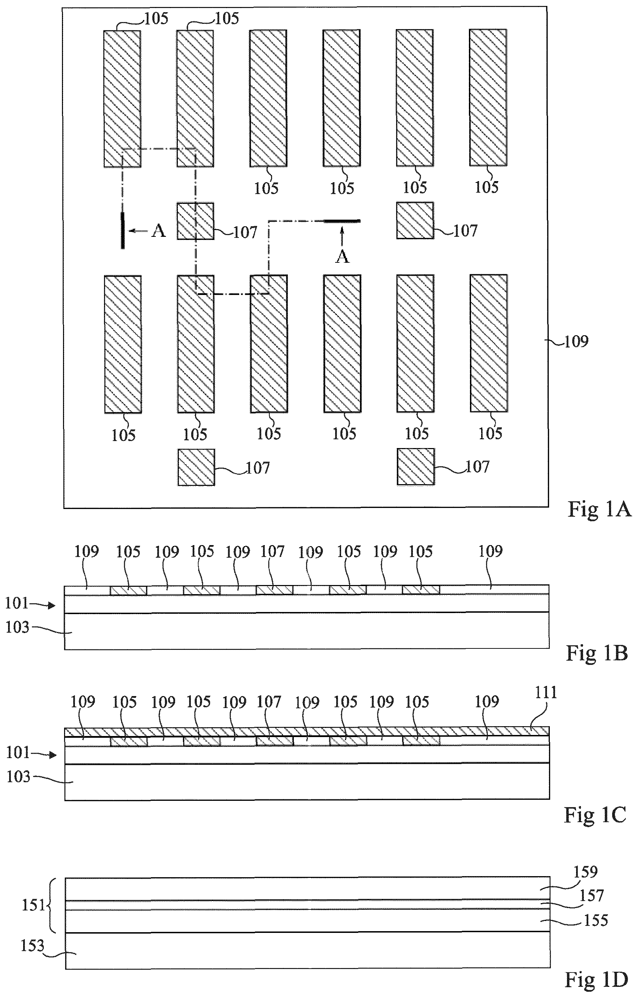

Les figures 1A à 1T sont des vues illustrant des étapes successives d'un exemple, non limitatif, de mise en œuvre d'un tel procédé. Diverses variantes sont à la portée de la personne du métier à partir des indications de la présente description.

On a représenté sur les figures 1A à 1T la réalisation d'un dispositif comportant des pixels comprenant chacun une unique diode photosensible et trois LED inorganiques. Cet exemple n'est toutefois pas limitatif, le procédé décrit pouvant bien entendu être adapté pour réaliser des dispositifs comportant des pixels comprenant des nombres de diodes photosensibles et de LED inorganiques différents de ceux représentés. En outre, les modes de réalisation décrits s'appliquent à des dispositifs présentant des plages de longueurs d'ondes d'émission et de réception quelconques, par exemple situées chacune dans l'infrarouge ou dans le visible.

Les figures 1A et 1B sont des vues, respectivement de dessus et en coupe selon le plan AA de la figure 1A, représentant de façon schématique et partielle un circuit intégré de contrôle 101 préalablement formé dans et sur un substrat semiconducteur 103. À titre d'exemple, le circuit intégré de contrôle 101 est formé dans et sur un substrat massif de silicium. À titre de variante, le substrat semiconducteur 103 est de type SOI (de l'anglais « Semiconductor On Insulator » - semiconducteur sur isolant) et comprend par exemple un support en silicium revêtu d'une couche isolante elle-même revêtue d'une couche en silicium monocristallin.

Dans l'exemple représenté, le circuit de contrôle 101 comprend, du côté de sa face supérieure, pour chacune des LED du dispositif, un plot métallique de connexion 105 destiné à être connecté à l'une des électrodes (anode ou cathode) de la LED, de façon à pouvoir commander un courant circulant dans la LED et/ou appliquer une tension aux bornes de la LED. Le circuit de contrôle 101 comprend par exemple, pour chaque LED connectée au plot métallique 105 dédié à la LED, une cellule élémentaire de contrôle comportant un ou plusieurs transistors, permettant de contrôler le courant circulant dans la LED et/ou la tension appliquée aux bornes de la LED.

Dans cet exemple, le circuit de contrôle 101 comprend en outre, du côté de sa face supérieure, pour chacune des diodes photosensibles du dispositif, un plot métallique 107 destiné à être connecté à l'une des électrodes (anode ou cathode) de la diode photosensible, de façon à pouvoir recevoir des charges photogénérées dans la diode photosensible. Le circuit de contrôle 101 comprend par exemple, pour chaque diode photosensible connectée au plot métallique 107 dédié à la diode photosensible, une cellule élémentaire de lecture comportant un ou plusieurs transistors, permettant par exemple de transférer les charges photogénérées dans la diode photosensible vers un nœud de lecture.

Dans l'exemple considéré où le dispositif comporte une unique diode photosensible et trois LED inorganiques par pixel, le circuit de contrôle 101 comprend trois fois plus de plots 105 que de plots 107. Comme illustré en figure 1A, les plots 105 et 107 forment par exemple un motif se répétant de façon régulière le long de lignes et de colonnes à la surface du circuit de contrôle 101.

Le circuit de contrôle 101 est par exemple réalisé en technologie CMOS (de l'anglais « Complementary Metal-Oxide-Semiconductor » - métal oxyde semiconducteur complémentaire). Les plots métalliques 105 et 107 peuvent être latéralement entourés par un matériau isolant 109, par exemple de l'oxyde de silicium, de façon que le circuit de contrôle 101 présente une surface supérieure sensiblement plane comprenant une alternance (ou damier) de régions métalliques 105, 107 et de régions isolantes 109. Le contact sur les électrodes des LED et des diodes photosensibles (cathodes ou anodes) non connectées aux plots 105, 107 peut être pris de façon collective, par exemple dans une région périphérique du circuit de contrôle 101, par l'intermédiaire d'un ou plusieurs plots de connexion (non visibles sur les figures) du circuit de contrôle 101.

La figure 1C est une vue en coupe, selon le plan AA de la figure 1A, illustrant une étape ultérieure de dépôt, sur la face supérieure du circuit de contrôle 101, d'une couche métallique 111. Dans l'exemple représenté, la couche métallique 111 revêt sensiblement toute la surface supérieure du circuit de contrôle 101. En particulier, la couche métallique 111 est en contact avec les plots métalliques de connexion 105 et 107 du circuit de contrôle 101.

La figure 1D est une vue en coupe représentant, de façon schématique et partielle, un empilement actif de LED inorganique 151, par exemple au nitrure de gallium, disposé sur la face supérieure d'un substrat de support 153. Le substrat de support 153 est par exemple un substrat en silicium, en saphir, en corindon, ou en tout autre matériau sur lequel un empilement actif de LED peut être déposé. Dans l'exemple représenté, l'empilement actif 151 comprend, dans l'ordre à partir de la surface supérieure du substrat 153, une couche 155 en un matériau semiconducteur dopé de type N, par exemple une couche de nitrure de gallium dopé de type N, une couche émissive 157, et une couche 159 en un matériau semiconducteur dopé de type P, par exemple une couche en nitrure de gallium dopé de type P. La couche émissive 157 est par exemple constituée par un empilement d'une ou plusieurs couches émissives formant chacune un puits quantique, par exemple à base de GaN, InN, InGaN, AlGaN, AlN, AlInGaN, GaP, AlGaP, AlInGaP, ou d'une combinaison d'un ou plusieurs de ces matériaux. Dans cet exemple, la face inférieure de la couche émissive 157 est en contact avec la face supérieure de la couche 155, et la face supérieure de la couche émissive 157 est en contact avec la face inférieure de la couche 159. En pratique, selon la nature du substrat 153, un empilement d'une ou plusieurs couches tampon (non représentées) peut faire interface entre le substrat de support 153 et la couche de nitrure de gallium 155. L'empilement actif 151 est par exemple formé par épitaxie sur le substrat de support 153.

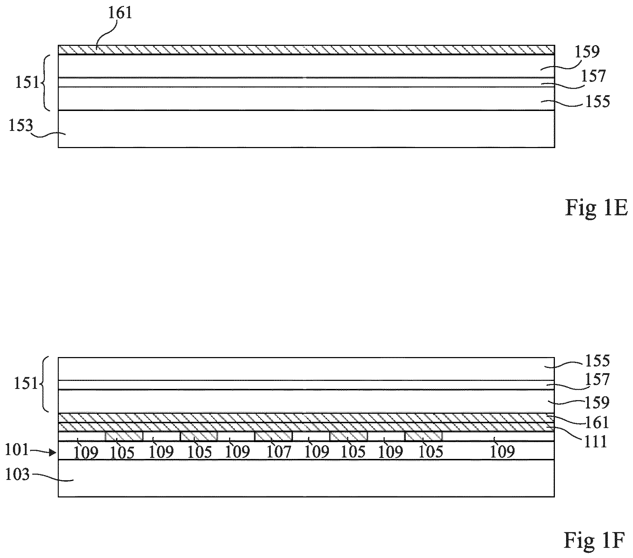

La figure 1E est une vue en coupe illustrant une étape ultérieure de dépôt, sur la face supérieure de l'empilement actif de LED 151, d'une couche métallique 161. Dans l'exemple représenté, la couche métallique 161 est disposée sur et en contact avec la face supérieure de la couche semiconductrice de type P 159. La couche métallique 161 revêt par exemple sensiblement toute la surface supérieure de l'empilement actif 151.

La figure 1F est une vue en coupe, selon le plan AA de la figure 1A, illustrant une étape ultérieure au cours de laquelle l'empilement actif de LED 151 est reporté sur la face supérieure du circuit de contrôle 101. Pour cela, l'ensemble comportant le substrat de support 153, l'empilement actif 151 et la couche métallique 161 peut être retourné, puis rapporté sur le circuit de contrôle 101, de façon à mettre en contact la face supérieure (dans l'orientation de la figure 1F) de la couche métallique 161 avec la face supérieure de la couche métallique 111. Au cours de cette étape, l'empilement actif 151 est fixé (bonded) au circuit de contrôle 101. À titre d'exemple, la fixation de l'empilement actif 151 sur le circuit de contrôle 101 peut être obtenue par collage moléculaire entre les deux surfaces mises en contact. À titre de variante, la fixation des deux surfaces peut être réalisée par thermocompression, collage eutectique, ou par toute autre méthode de fixation adaptée.

En outre, au cours de cette étape, le substrat de support 153 de l'empilement actif de LED 151 est retiré de façon à découvrir la face supérieure (dans l'orientation de la figure 1F) de la couche semiconductrice de type N 155. Le substrat 153 est par exemple retiré par meulage et/ou gravure à partir de sa face opposée à l'empilement actif 151. À titre de variante, dans le cas d'un substrat 153 transparent, par exemple un substrat en saphir ou en corindon, le substrat 153 peut être détaché de l'empilement actif 151 au moyen d'un faisceau laser projeté à travers le substrat 153 depuis sa face opposée à l'empilement actif 151 (procédé de type laser lift-off). Plus généralement, toute autre méthode permettant de retirer le substrat 153 peut être utilisée. Après le retrait du substrat 153, une étape supplémentaire de gravure peut être prévue pour retirer d'éventuelles couches tampon subsistant du côté de la face supérieure de la couche semiconductrice 155. En outre, une partie de l'épaisseur de la couche semiconductrice 155 peut être retirée, par exemple par gravure. À l'issue de cette étape, l'empilement actif 151 revêt sensiblement toute la surface du circuit de contrôle 101, sans discontinuité. À titre d'exemple, l'épaisseur de l'empilement actif 151 après le retrait du substrat de support 153 est comprise entre 0,5 et 2 µm.

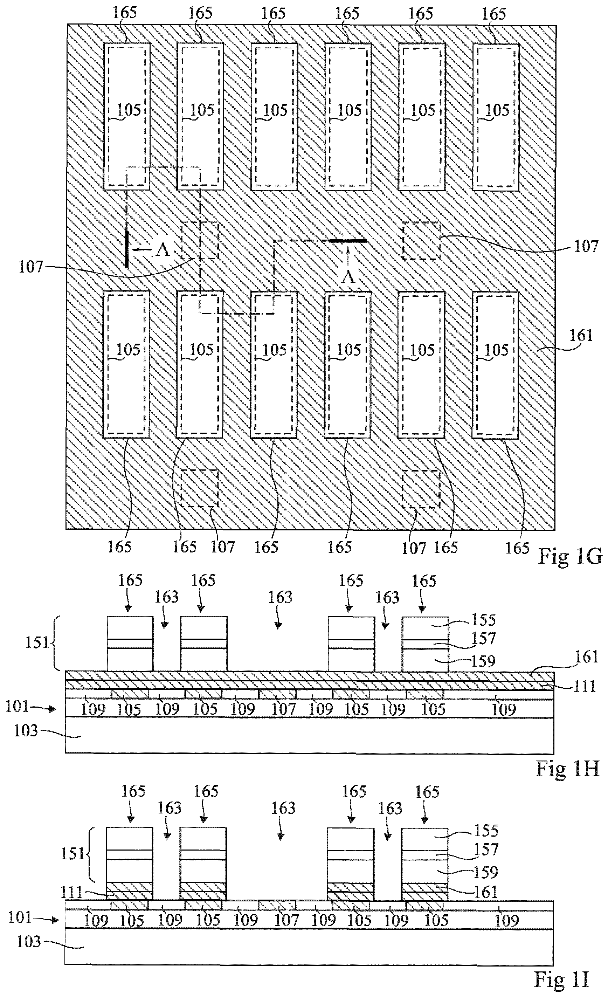

Les figures 1G et 1H sont des vues, respectivement de dessus et en coupe selon le plan AA de la figure 1G, représentant une étape ultérieure de formation d'ouvertures ou tranchées traversantes 163 dans l'empilement actif 151, par exemple par gravure plasma au travers d'un masque (non représenté) préalablement déposé du côté de la face supérieure de l'empilement actif 151. Les tranchées 163 s'étendent depuis la face supérieure de la couche semiconductrice de type N 155 à travers les couches 155, 157 et 159 de l'empilement actif 151, la gravure étant interrompue sur la face supérieure de la couche métallique 161. La formation des tranchées 163 à travers l'empilement actif 151 conduit à délimiter, dans l'empilement actif 151, une pluralité de LED 165. Chaque LED 165 correspond à un îlot ou mesa formé dans l'empilement 151 et entouré latéralement par une tranchée 163. Chaque LED 165 comprend ainsi un empilement vertical comportant, dans l'ordre à partir de la surface supérieure de la couche métallique 161, une portion de la couche semiconductrice de type P 159, correspondant à l'anode de la LED, une portion de la couche émissive 157, et une portion de la couche semiconductrice de type N 155, correspondant à la cathode de la LED. Les tranchées 163 peuvent être alignées par rapport à des repères préalablement formés sur le circuit de contrôle 101. Plus particulièrement, après le dépôt du masque de gravure mais avant la formation des tranchées 163, des repères préalablement formés sur le substrat 103 peuvent être dégagés par gravure du masque et de l'empilement actif 151 dans des zones périphériques de l'assemblage, ces repères servant ensuite de marques d'alignement pour le positionnement du masque utilisé pour réaliser les tranchées 163. Dans l'exemple représenté, chaque LED 165 est située, en projection verticale, en regard d'un unique plot métallique 105 du circuit de contrôle 101. Dans cet exemple, les tranchées 163 sont situées, en projection verticale, en regard des plots métalliques 107 des futures diodes photosensibles et des régions isolantes 109 de la face supérieure du circuit de contrôle 101.

La figure 1I est une vue en coupe, selon le plan AA de la figure 1G, illustrant une étape ultérieure de retrait, par exemple par gravure plasma, des portions des couches métalliques 161 et 111 situées au fond des tranchées 163, de façon à prolonger les tranchées 163 jusqu'aux régions métalliques 107 et isolantes 109 de la face supérieure du circuit de contrôle 101. À l'issue de cette étape, les anodes (régions 159) des différentes LED 165 sont isolées électriquement les unes des autres par les tranchées 163, et chaque LED 165 a son anode connectée au plot métallique 105 sous-jacent par l'intermédiaire des portions des couches métalliques 161 et 111 subsistant entre la LED et le plot 105. Ceci permet un contrôle individuel des LED par le circuit de contrôle 101. En outre, à l'issue de cette étape, la face supérieure des régions métalliques 107 est découverte.

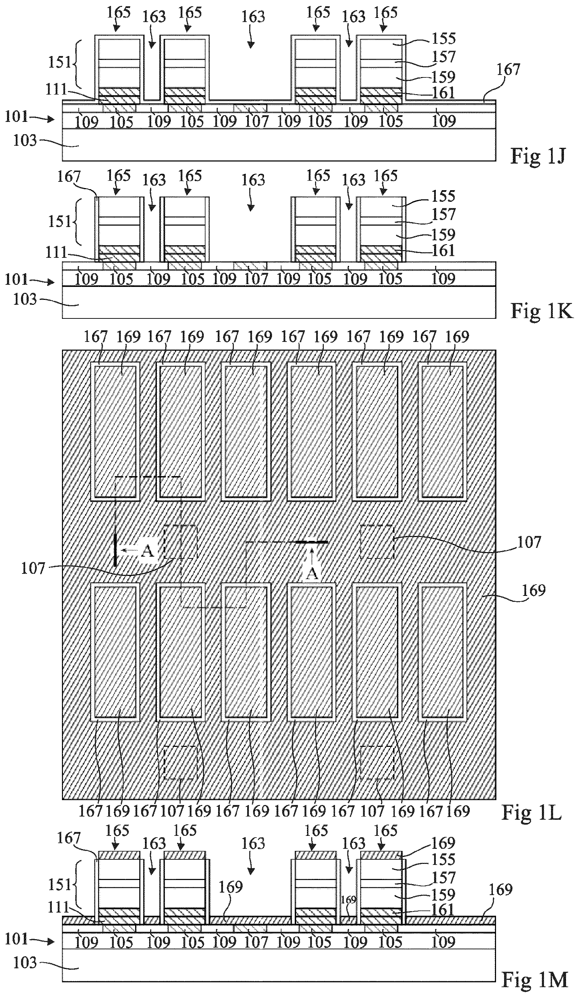

La figure 1J est une vue en coupe, selon le plan AA de la figure 1G, illustrant une étape ultérieure de dépôt d'une couche isolante 167, par exemple une couche de passivation en oxyde ou en nitrure de silicium ou en oxyde d'aluminium, sur les parois latérales et sur le fond des tranchées 163. Dans l'exemple représenté, la couche 167 est en outre déposée sur la face supérieure des portions de l'empilement actif 151 des LED 165. La couche 167 est par exemple déposée sur toute la surface supérieure du dispositif par une méthode de dépôt conforme, par exemple par dépôt en couches monoatomiques successives (ALD). À titre d'exemple, l'épaisseur de la couche 167 est comprise entre 10 nm et 1 µm.

La figure 1K est une vue en coupe, selon le plan AA de la figure 1G, illustrant une étape ultérieure de retrait de la couche isolante 167 au fond des tranchées 163. Lors de cette étape, la couche 167 est conservée sur les parois latérales, ou flancs, des tranchées 163. Pour cela, la couche 167 est par exemple gravée par gravure anisotrope verticale, ce qui conduit en outre à retirer la couche 167 sur la face supérieure des portions de l'empilement actif 151 surmontant les LED 165.

Dans un cas où les LED et les diodes photosensibles du dispositif présentent des longueurs d'ondes de fonctionnement (c'est-à-dire d'émission et de détection, respectivement) voisines, un empilement d'une ou plusieurs couches opaques (non représentées) d'isolation optique latérale, adaptées à bloquer l'émission de lumière des LED en direction des diodes photosensibles, peut revêtir les portions de la couche 167 qui subsistent sur les flancs des LED 165 afin d'éviter notamment des phénomènes de diaphotie (optical crosstalk). L'empilement est par exemple constitué d'une ou plusieurs couches métalliques minces, d'une ou plusieurs couches de résine organique noire, ou d'une combinaison d'une ou plusieurs de ces couches.

Les figures 1L et 1M sont des vues, respectivement de dessus et en coupe selon le plan AA de la figure 1L, illustrant une étape ultérieure de dépôt anisotrope, du côté de la face supérieure du circuit de contrôle 101, d'une couche électriquement conductrice 169. Dans l'exemple représenté, la couche conductrice 169 revêt la face supérieure des LED 165 ainsi que le fond des tranchées 163, mais ne revêt pas les flancs des LED 165. Plus précisément, dans cet exemple, la couche conductrice 169 revêt la face supérieure des portions de la couche semiconductrice de type N 155 des LED 165 ainsi que les régions métalliques 107 et isolantes 109 du circuit de contrôle 101 préalablement exposées au fond des tranchées 163, mais ne revêt pas les portions de la couche isolante 167. À titre d'exemple, la couche électriquement conductrice 169 est en un métal, un alliage métallique, ou un oxyde conducteur transparent (« Transparent Conductive Oxide » - TCO, en anglais), par exemple l'oxyde d'indium-étain (« Indium Tin Oxide » - ITO, en anglais).

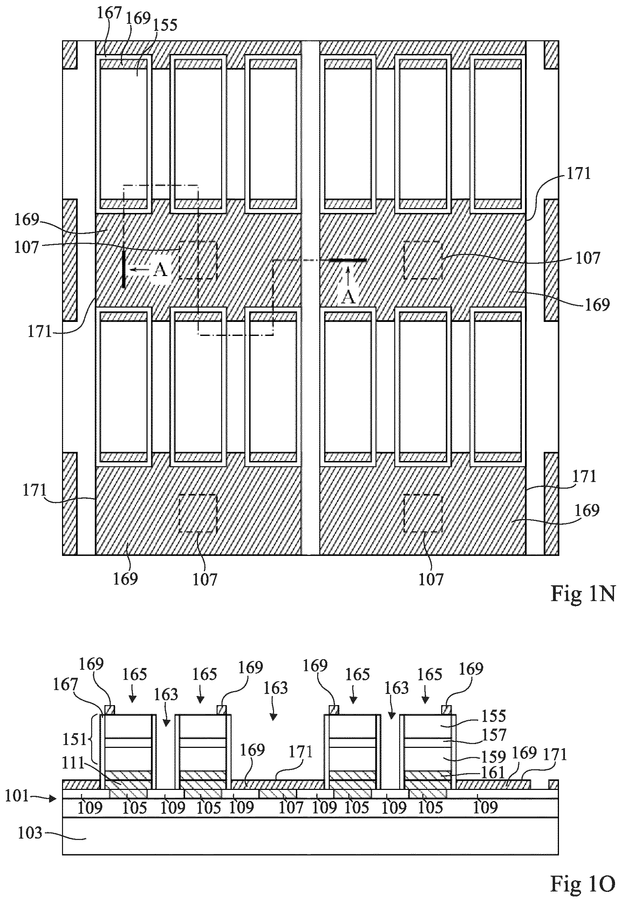

Les figures 1N et 1O sont des vues, respectivement de dessus et en coupe selon le plan AA de la figure 1N, illustrant une étape ultérieure de retrait localisé de la couche conductrice 169, par exemple par photolithographie puis gravure. À titre d'exemple, lors de cette étape, un masque de gravure (non représenté), par exemple formé par photolithographie, peut être disposé sur la face supérieure de la structure, ce masque étant ouvert en vis-à-vis de portions de la couche conductrice 169 à retirer. Le masque peut ensuite être retiré après la gravure.

Au cours de cette étape, on retire plus précisément des portions de la couche 169 revêtant la face supérieure de la couche 155 des LED 165 du dispositif. Dans le cas où la couche conductrice 169 est en un matériau opaque aux longueurs d'ondes d'émission des LED 165, par exemple un métal opaque, la surface d'émission de la LED 165 est définie par une zone de la couche 155 au-dessus de laquelle la couche conductrice 169 a été retirée. On a donc par exemple intérêt, dans ce cas, à retirer la majeure partie de la couche 169 en surface des portions de la couche 155 de sorte à pouvoir bénéficier d'une surface d'émission maximale. À titre de variante, dans le cas où la couche conductrice 169 est en un matériau transparent aux longueurs d'ondes d'émission des LED 165, par exemple un oxyde conducteur transparent, les portions de la couche 169 revêtant la face supérieure des LED 165 peuvent être conservées.

En outre, au cours de cette étape, on retire des portions de la couche conductrice 169 revêtant les régions isolantes 109 du circuit de contrôle 101 de sorte à définir, dans la couche conductrice 169, une pluralité d'électrodes d'anode 171 des futures diodes photosensibles du dispositif. Dans l'exemple représenté, chaque électrode d'anode 171 est située, en projection verticale, en regard d'un unique plot métallique 107 du circuit de contrôle 101. À l'issue de cette étape, les électrodes d'anode 171 des futures diodes photosensibles sont isolées électriquement les unes des autres, chaque électrode d'anode 171 étant en outre connectée au plot métallique 107 sous-jacent. Ceci permet un contrôle individuel des diodes photosensibles par le circuit de contrôle 101.

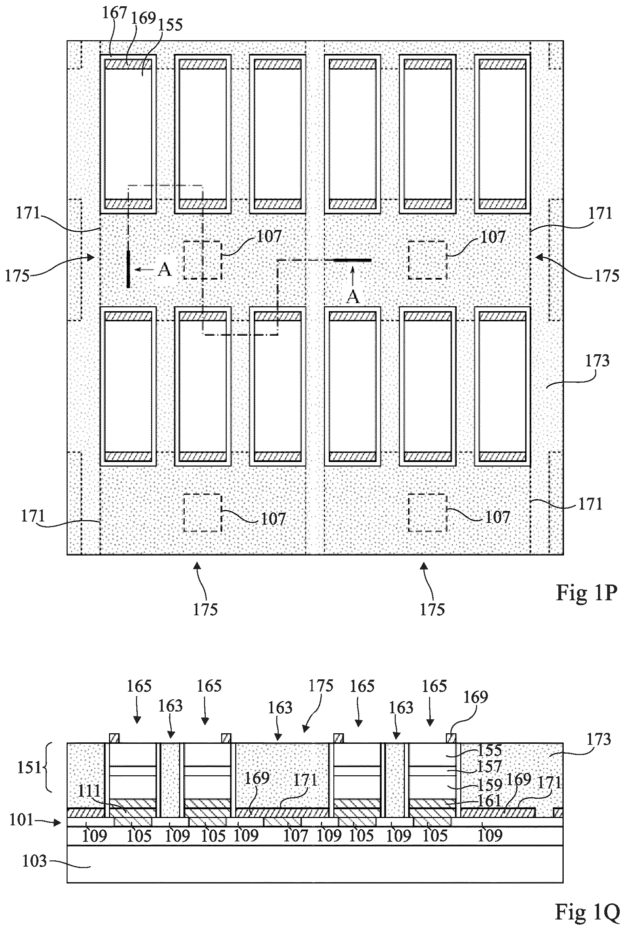

Les figures 1P et 1Q sont des vues, respectivement de dessus et en coupe selon le plan AA de la figure 1P, illustrant une étape ultérieure de dépôt d'une couche active semiconductrice photosensible 173, qui selon l'invention telle que revendiquée est une couche de photodétection, sur les parois latérales et sur le fond des tranchées 163. Dans l'exemple représenté, la couche 173 comble entièrement les tranchées 163, de sorte que la couche 173 affleure la partie supérieure de l'empilement actif de LED 151. En d'autres termes, la couche 173 remplit totalement tous les espaces laissés libres entre les LED 165. Dit autrement, il ne subsiste aucun espace libre entre les LED 165 après le dépôt de la couche active semiconductrice 173. À titre de variante, la couche 173 peut présenter une hauteur inférieure à celle de l'empilement 151, par exemple comprise entre 0,5 et 1 µm.

Selon un mode de réalisation de l'invention, la couche active 173 est une couche organique comportant un ou plusieurs matériaux polymères semiconducteurs, une couche comportant des boîtes quantiques (« quantum dots » - QDs, en anglais), ou une couche comportant des boîtes quantiques dans une matrice polymère, ou encore tout type de couche organique remplissant une fonction de capture de photons. Dans la présente description, le terme « couche organique » inclut une couche organique intégrant des boîtes quantiques inorganiques. À titre d'exemple, la couche organique comprend des nanocristaux inorganiques entourés de ligands organiques. Selon le matériau considéré, le dépôt de la couche active 173 peut être réalisé par exemple par voie liquide. Plus précisément, la couche active 173 peut par exemple être obtenue par une technique de dépôt à la tournette (« spin-coating », en anglais) ou de revêtement à la lame (« blade-coating », en anglais) d'une solution de polymère et/ou de boîtes quantiques, par exemple une solution colloïdale de nanocristaux semiconducteurs. En pratique, un empilement d'une ou plusieurs couches d'injection et/ou de transport de trous (non représentées) peut être déposé sur le fond des tranchées 163 préalablement au dépôt de la couche active 173.

Le remplissage des tranchées 163 par la couche active 173 conduit à former une pluralité de diodes photosensibles 175, ou photodétecteurs. Chaque diode photosensible 175 comprend un empilement vertical comportant, dans l'ordre à partir de la surface supérieure du circuit de contrôle 101, une portion de la couche conductrice 169, correspondant à l'électrode d'anode 171 de la diode photosensible, et une portion de la couche active 173 située sensiblement à l'aplomb de l'anode 171. De façon avantageuse, la couche active 173 présente par exemple des propriétés de conduction électrique anisotropes. Plus précisément, la couche active 173 présente par exemple une faible conduction électrique latérale, permettant d'isoler électriquement chaque diode photosensible 175 par rapport aux diodes photosensibles voisines, et une conduction électrique verticale forte, par exemple supérieure à la conduction électrique latérale, de sorte à faciliter le transport vertical des porteurs photogénérés dans la couche active 173 vers les électrodes de la diode photosensible 175. En pratique, un empilement d'une ou plusieurs couches d'injection et/ou de transport d'électrons (non représentées) peut ultérieurement être déposé sur la couche active 173.

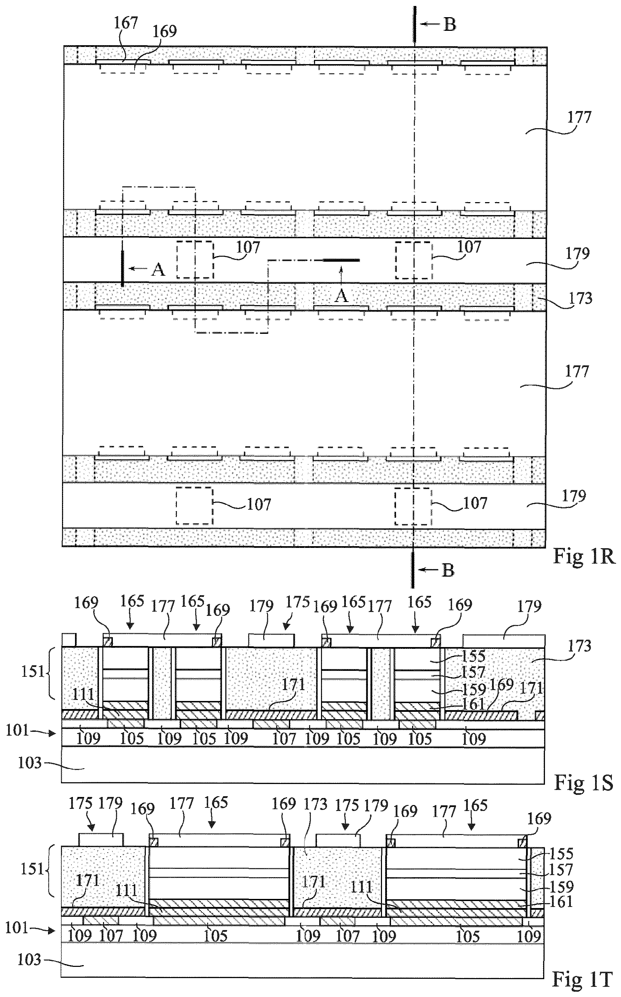

La figure 1R est une vue de dessus illustrant une étape ultérieure de réalisation de l'électrode de cathode commune sur les empilements des LED 165 et des diodes photosensibles 175 du dispositif. Les figures 1S et 1T sont des vues en coupe, selon les plans respectivement AA et BB de la figure 1R, de cette même étape. Dans l'exemple représenté, on forme plus précisément des électrodes de cathode 177 communes à toutes les LED 165 d'une même rangée de LED du dispositif et des électrodes de cathode 179 communes à toutes les diodes photosensibles 175 d'une même rangée de diodes photosensibles du dispositif. Les électrodes de cathode 177 et 179 sont par exemple en un oxyde conducteur transparent, par exemple l'ITO. Le matériau des électrodes de cathode 177 et 179 est par exemple déposé sur toute la surface de l'empilement, par exemple par dépôt physique en phase vapeur (« Physical Vapor Deposition » - PVD, en anglais), puis recuit à une température d'environ 100 °C. Le matériau est ensuite gravé, par exemple par gravure plasma à faible énergie ou par gravure humide, par exemple à base d'acide chlorhydrique, de sorte à former les électrodes de cathode communes 177 et 179. À titre de variante, dans un cas où les LED 165 et les diodes photosensibles 175 du dispositif présentent des tensions de polarisation semblables, on peut prévoir une unique électrode de cathode commune à toutes les LED 165 et à toutes les diodes photosensibles 175 du dispositif, le contrôle individuel des LED 165 et des diodes photosensibles 175 s'effectuant par les plots conducteurs 105 et 107, respectivement.

Dans l'exemple représenté, on obtient, à l'issue des étapes décrites en relation avec les figures 1A à 1T, un dispositif combinant des fonctions d'émission lumineuse et de photodétection.

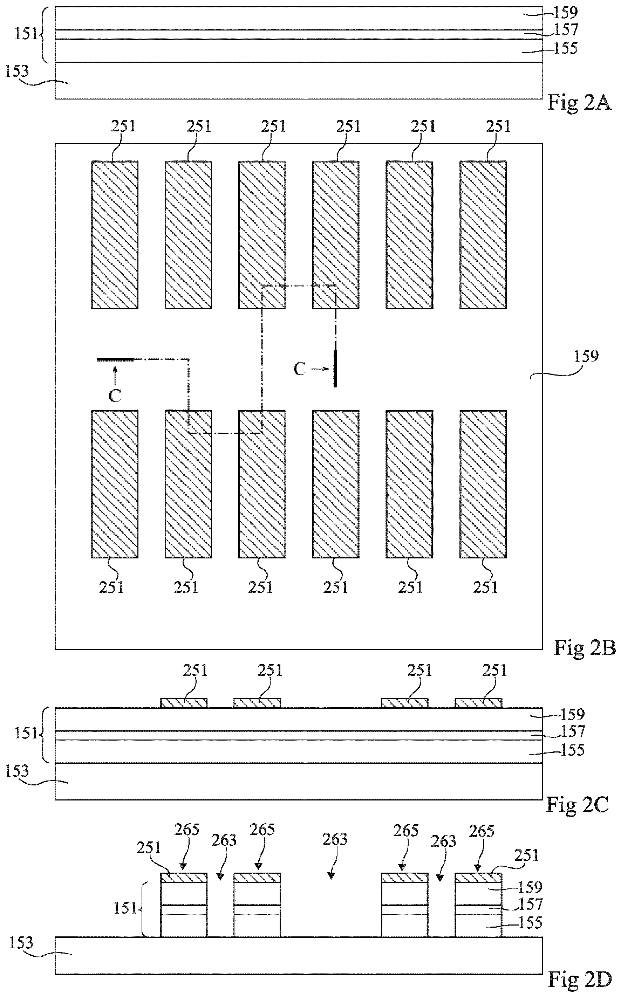

Les figures 2A à 2V sont des vues schématiques et partielles illustrant d'autres étapes successives d'un exemple d'un procédé de fabrication d'un dispositif optoélectronique selon un mode de réalisation.

La figure 2A est une vue en coupe représentant de façon schématique et partielle un empilement actif de LED disposé sur la face supérieure d'un substrat de support. L'empilement actif de LED et le substrat de support illustrés en figure 2A sont par exemple similaires à l'empilement actif de LED 151 et au substrat de support 153 précédemment décrits en relation avec la figure 1D, et ne seront pas détaillés à nouveau ci-après.

Les figures 2B et 2C sont des vues, respectivement de dessus et en coupe selon le plan CC de la figure 2B, illustrant une étape ultérieure de formation, du côté de la face supérieure de l'empilement actif de LED 151, pour chacune des LED du dispositif, d'un plot métallique de connexion 251 destiné à être connecté à l'une des électrodes (anode ou cathode) de la LED, de façon à pouvoir commander un courant circulant dans la LED et/ou appliquer une tension aux bornes de la LED. À titre d'exemple, les plots métalliques de connexion 251 sont formés par photolithographie puis gravure à partir d'une couche métallique déposée sur toute la surface supérieure de la couche semiconductrice de type P 159 de l'empilement actif de LED 151.

La figure 2D est une vue en coupe, selon le plan CC de la figure 2B, représentant une étape ultérieure de formation d'ouvertures ou tranchées traversantes 263 dans l'empilement actif 151, par exemple par gravure plasma. Lors de la gravure, les plots métalliques de connexion 251 jouent par exemple le rôle d'un masque. Les tranchées 263 s'étendent depuis la face supérieure de la couche semiconductrice de type P 159 à travers les couches 159, 157 et 155 de l'empilement LED 151, la gravure étant interrompue sur la face supérieure du substrat de support 153. La formation des tranchées 263 à travers l'empilement actif 151 conduit à délimiter, dans l'empilement actif 151, une pluralité de LED 265. Chaque LED 265 correspond à un îlot ou mesa formé dans l'empilement 151 et entouré latéralement par une tranchée 263. Ainsi, chaque LED 265 comprend un empilement vertical comportant, dans l'ordre à partir de la surface supérieure du substrat de support 153, une portion de la couche semiconductrice de type N 155, correspondant à la cathode de la LED, une portion de la couche émissive 157, une portion de la couche semiconductrice de type P 159, correspondant à l'anode de la LED, et un plot métallique de connexion 251.

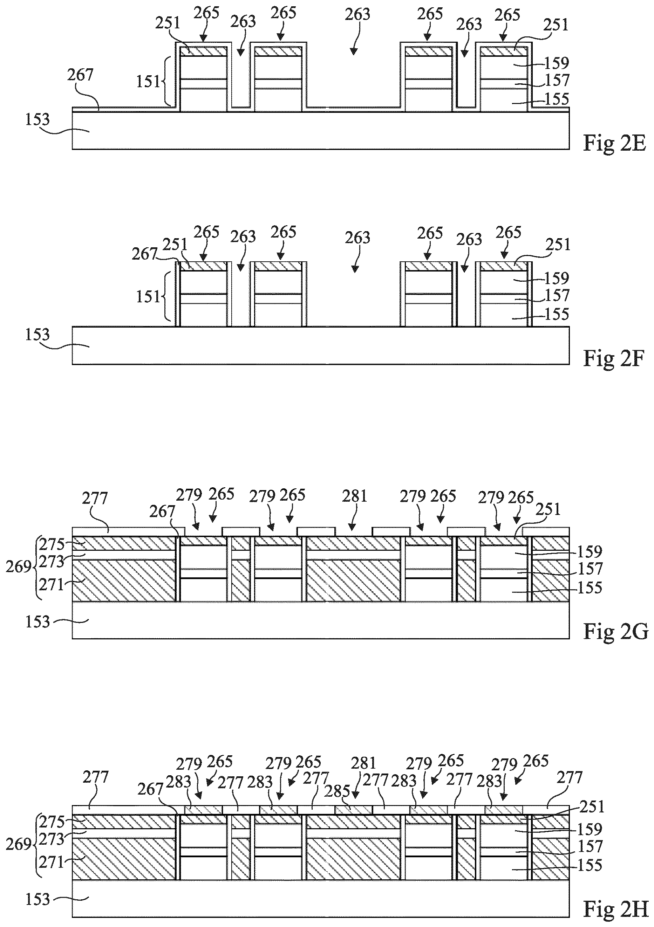

La figure 2E est une vue en coupe, selon le plan CC de la figure 2B, illustrant une étape ultérieure de dépôt d'une couche isolante 267, par exemple une couche de passivation en oxyde ou en nitrure de silicium, sur les parois latérales et sur le fond des tranchées 263. Dans l'exemple représenté, la couche 267 revêt en outre les parois latérales et la face supérieure des plots métalliques de connexion 251. La couche 267 est par exemple déposée sur toute la surface supérieure du dispositif par une méthode de dépôt conforme, par exemple par dépôt en couches monoatomiques successives (ALD). À titre d'exemple, l'épaisseur de la couche 267 est comprise entre 10 nm et 1 µm.

La figure 2F est une vue en coupe, selon le plan CC de la figure 2B, illustrant une étape ultérieure de retrait de la couche isolante 267 au fond des tranchées 263. Lors de cette étape, la couche 267 est conservée sur les parois latérales ou flancs des tranchées 263 et des plots métalliques de connexion 251. Pour cela, la couche 267 est par exemple gravée par gravure anisotrope verticale, ce qui conduit en outre à retirer la couche 267 sur la face supérieure des plots métalliques de connexion 251 surmontant les LED 265.

Dans un cas analogue à ce qui a été décrit précédemment en relation avec la figure 1K, lorsque les LED et les diodes photosensibles du dispositif présentent des longueurs d'ondes de fonctionnement (c'est-à-dire d'émission et de détection, respectivement) voisines, un empilement d'une ou plusieurs couches opaques (non représentées) d'isolation optique latérale, adaptées à bloquer l'émission de lumière des LED en direction des diodes photosensibles, peut revêtir les portions de la couche 267 qui subsistent sur les flancs des LED 265. L'empilement est par exemple constitué d'une ou plusieurs couches métalliques minces, d'une ou plusieurs couches de résine organique noire, ou d'une combinaison d'une ou plusieurs de ces couches.

La figure 2G est une vue en coupe selon le plan CC de la figure 2B, illustrant une étape ultérieure de dépôt d'un empilement 269 de couches électriquement conductrices et électriquement isolantes sur le fond des tranchées 263. Dans l'exemple représenté, l'empilement 269 comprend, dans l'ordre à partir de la surface supérieure du substrat 153, une couche conductrice 271, par exemple une couche métallique, une couche isolante 273, par exemple en oxyde de silicium, et une autre couche conductrice 275, par exemple une couche métallique. Dans cet exemple, la face inférieure de la couche isolante 273 est en contact avec la face supérieure de la couche conductrice 271, et la face supérieure de la couche isolante 273 est en contact avec la face inférieure de la couche conductrice 275. Dans l'exemple représenté, l'empilement 269 comble entièrement les tranchées 263, de sorte que la couche conductrice 275 affleure la face supérieure des plots métalliques de connexion 251.

En outre, au cours de cette étape, une couche électriquement isolante 277 est déposée sur la face supérieure de la structure. La couche isolante 277 revêt par exemple sensiblement toute la surface supérieure de la couche conductrice 275 et toute la surface supérieure des plots métalliques de connexion 251.

Des ouvertures ou tranchées traversantes 279 sont ensuite formées dans la couche isolante 277, en regard des plots métalliques de connexion 251, de sorte à découvrir au moins partiellement la face supérieure des plots métalliques de connexion 251. En outre, au cours de cette étape, on forme d'autres ouvertures ou tranchées traversantes 281 dans la couche isolante 277. Les tranchées 281 sont par exemple à l'aplomb de zones situées entre les LED 265 où l'on souhaite réaliser ultérieurement les diodes photosensibles du dispositif. À titre d'exemple, les tranchées 279 et 281 sont formées par photolithographie puis gravure de la couche isolante 277.

La figure 2H est une vue en coupe, selon le plan CC de la figure 2B, illustrant une étape ultérieure de formation, à l'intérieur des tranchées 279, de plots métalliques de connexion 283. Dans l'exemple représenté, les plots 283 sont situés sur et en contact avec la face supérieure des plots métalliques de connexion 251 et comblent entièrement les tranchées 279, c'est-à-dire que les plots 283 affleurent la face supérieure de la couche isolante 277. En outre, lors de cette étape, des plots métalliques de connexion 285 sont formés à l'intérieur des tranchées 281. Dans l'exemple représenté, les plots 285 sont situés sur et en contact avec la face supérieure de la couche conductrice 275 et comblent entièrement les tranchées 281, c'est-à-dire que les plots 285 affleurent la face supérieure de la couche isolante 277. À titre d'exemple, les plots métalliques de connexion 283 et 285 ainsi que les portions de couche isolante 277 subsistant entre ces plots sont obtenus par un procédé de type "damascène".

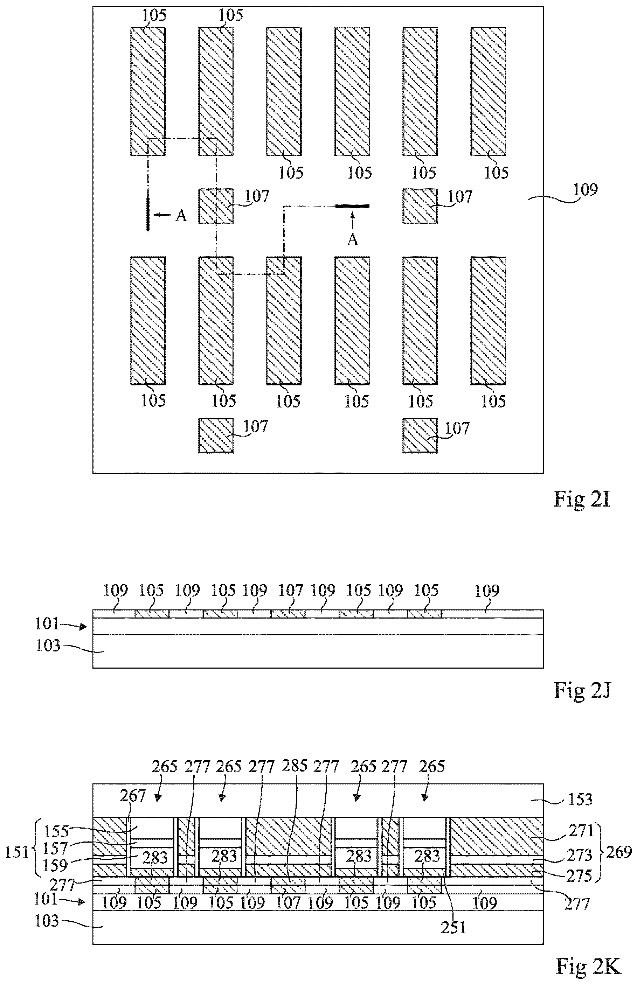

Les figures 2I et 2J sont des vues, respectivement de dessus et en coupe selon le plan AA de la figure 2I, représentant de façon schématique et partielle un circuit intégré de contrôle préalablement formé dans et sur un substrat semiconducteur. Le circuit intégré de contrôle et le substrat semiconducteur illustrés en figures 2I et 2J sont par exemple similaires au circuit intégré de contrôle 101 et au substrat semiconducteur 103 précédemment décrits en relation avec les figures 1A et 1B, et ne seront pas détaillés à nouveau ci-après.

La figure 2K est une vue en coupe, selon le plan AA de la figure 2I, illustrant une étape ultérieure au cours de laquelle les LED 265 sont reportées sur la face supérieure du circuit de contrôle 101. Pour cela, l'ensemble obtenu à l'issue de l'étape précédemment décrite en relation avec la figure 2H peut être retourné, puis rapporté sur le circuit de contrôle 101, de façon à mettre en contact la face inférieure (dans l'orientation de la figure 2K) de la couche isolante 277 avec la face supérieure de la couche isolante 109, la face inférieure des plots 283 avec la face supérieure des plots 105, et la face inférieure des plots 285 avec la face supérieure des plots 107. Au cours de cette étape, les LED 265 sont fixées (bonded) au circuit de contrôle 101. À titre d'exemple, la fixation des LED 265 sur le circuit de contrôle 101 peut être obtenue par collage moléculaire hybride entre les deux surfaces mises en contact. À titre de variante, la fixation des deux surfaces peut être réalisée par thermocompression, collage eutectique, ou par toute autre méthode de fixation adaptée. À l'issue de cette étape, chaque LED 265 a son anode (région 159) connectée au plot métallique 105 sous-jacent par l'intermédiaire des plots 283 et 251 entre la LED et le plot 105. Ceci permet un contrôle individuel des LED par le circuit de contrôle 101.

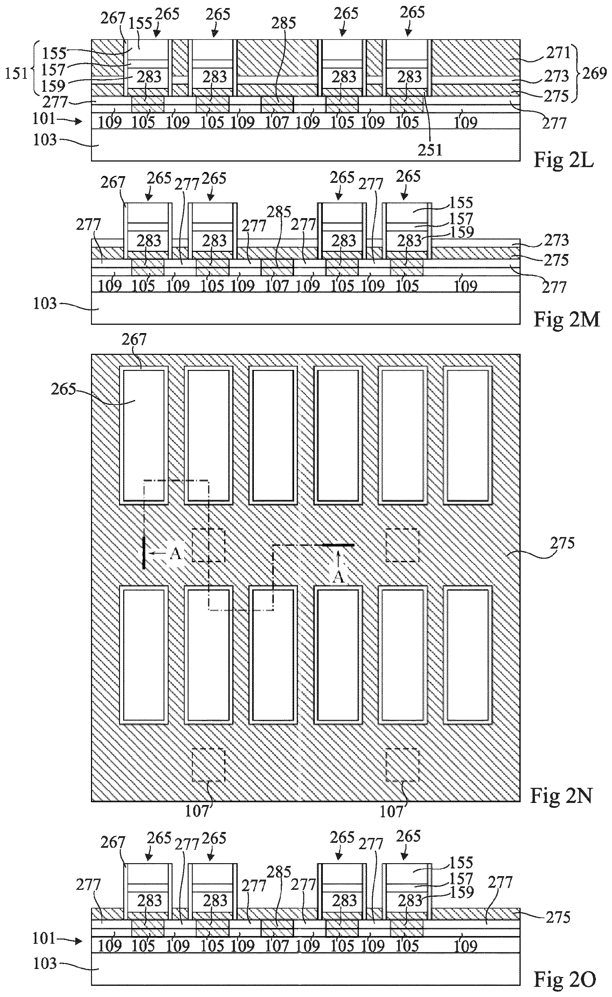

La figure 2L est une vue en coupe, selon le plan AA de la figure 2I, illustrant une étape ultérieure au cours de laquelle le substrat de support 153 est retiré de façon à découvrir la face supérieure (dans l'orientation de la figure 2L) de la couche semiconductrice de type N 155. Le substrat 153 est par exemple retiré par meulage et/ou gravure à partir de sa face opposée à l'empilement actif 151. À titre de variante, dans le cas d'un substrat 153 transparent, par exemple un substrat en saphir ou en corindon, le substrat 153 peut être détaché de l'empilement actif 151 au moyen d'un faisceau laser projeté à travers le substrat 153 depuis sa face opposée à l'empilement actif 151 (procédé de type laser lift-off). Plus généralement, toute autre méthode permettant de retirer le substrat 153 peut être utilisée. Après le retrait du substrat 153, une étape supplémentaire de gravure peut être prévue pour retirer d'éventuelles couches tampon subsistant du côté de la face supérieure de la couche semiconductrice 155. En outre, une partie de l'épaisseur de la couche semiconductrice 155 peut être retirée, par exemple par gravure.

La figure 2M est une vue en coupe, selon le plan AA de la figure 2I, illustrant une étape ultérieure de retrait de l'intégralité de la couche conductrice 271. Selon un mode de réalisation, la couche conductrice 271 est retirée par gravure, la couche isolante 273 servant par exemple de couche d'arrêt.

Les figures 2N et 2O sont des vues, respectivement de dessus et en coupe selon le plan AA de la figure 2N, illustrant une étape ultérieure de retrait de l'intégralité de la couche isolante 273.

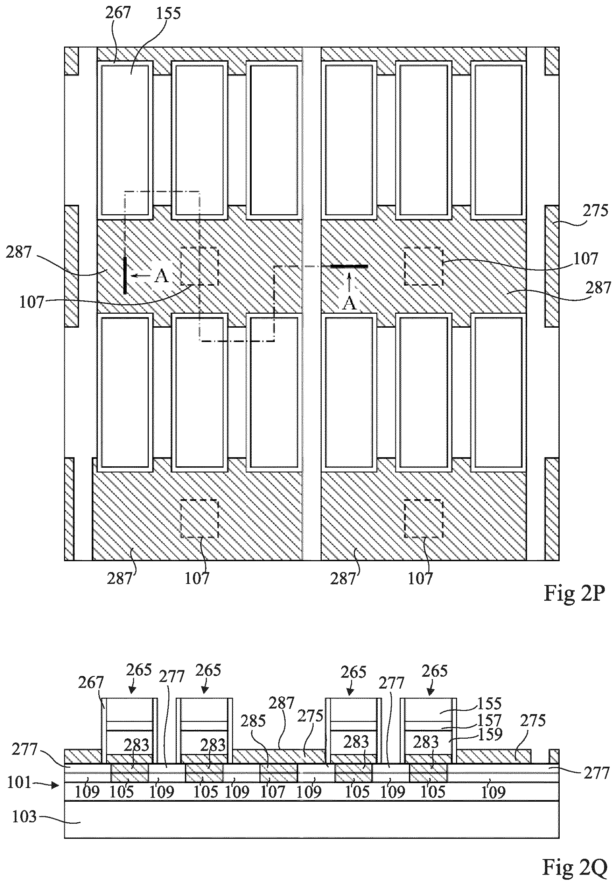

Les figures 2P et 2Q sont des vues, respectivement de dessus et en coupe selon le plan AA de la figure 2P, illustrant une étape ultérieure de retrait localisé de la couche conductrice 275, par exemple par photolithographie puis gravure. À titre d'exemple, lors de cette étape, un masque de gravure (non représenté), par exemple formé par photolithographie, peut être disposé sur la face supérieure de la structure, ce masque étant ouvert en vis-à-vis de portions de la couche conductrice 275 à retirer. Le masque peut ensuite être retiré après la gravure.

Au cours de cette étape, on retire par exemple plus précisément des portions de la couche conductrice 275 de sorte à définir, dans la couche conductrice 275, une pluralité d'électrodes d'anode 287 des futures diodes photosensibles du dispositif. Dans l'exemple représenté, chaque électrode d'anode 287 est située, en projection verticale, en regard d'un unique plot métallique 107 du circuit de contrôle 101. À l'issue de cette étape, les électrodes d'anode 287 des futures diodes photosensibles sont isolées électriquement les unes des autres, chaque électrode d'anode 287 étant en outre connectée au plot métallique 107 sous-jacent. Ceci permet un contrôle individuel des diodes photosensibles par le circuit de contrôle 101.

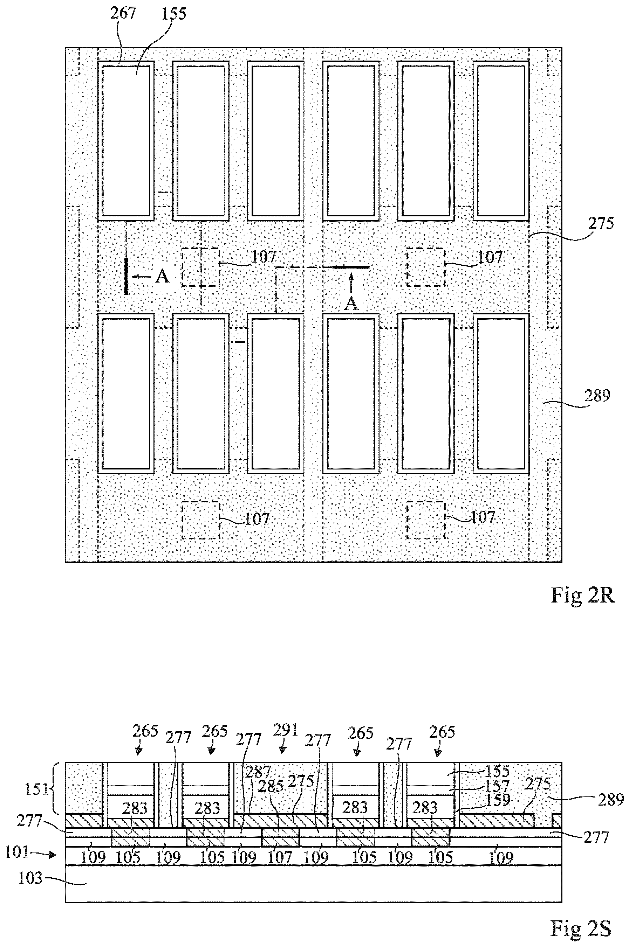

Les figures 2R et 2S sont des vues, respectivement de dessus et en coupe selon le plan AA de la figure 2R, illustrant une étape ultérieure de dépôt d'une couche active semiconductrice photosensible 289, ou couche de photodétection, du côté de la face supérieure de la structure obtenue à l'issue de l'étape précédente. Dans l'exemple représenté, la couche 289 comble entièrement des espaces s'étendant latéralement entre les LED 265, de sorte que la couche 289 affleure la face supérieure de la couche 155 des LED 265. À titre de variante, la couche 289 peut présenter une hauteur inférieure à celle de l'empilement 151, par exemple comprise entre 0,5 et 1 µm. La couche active 289 est par exemple en le même matériau que la couche 173 précédemment décrite en relation avec les figures 1P et 1Q.

Le remplissage des espaces libres entre les LED 265 par la couche active 289 conduit à former une pluralité de diodes photosensibles 291, ou photodétecteurs. Chaque diode photosensible 291 comprend un empilement vertical comportant, dans l'ordre à partir de la surface supérieure du circuit de contrôle 101, le plot 285, une portion de la couche conductrice 275, correspondant à l'électrode d'anode 287 de la diode photosensible, et une portion de la couche active 289 située sensiblement à l'aplomb de l'électrode d'anode 287. En pratique, un empilement d'une ou plusieurs couches d'injection et/ou de transport d'électrons (non représentées) peut ultérieurement être déposé sur la couche active 289.

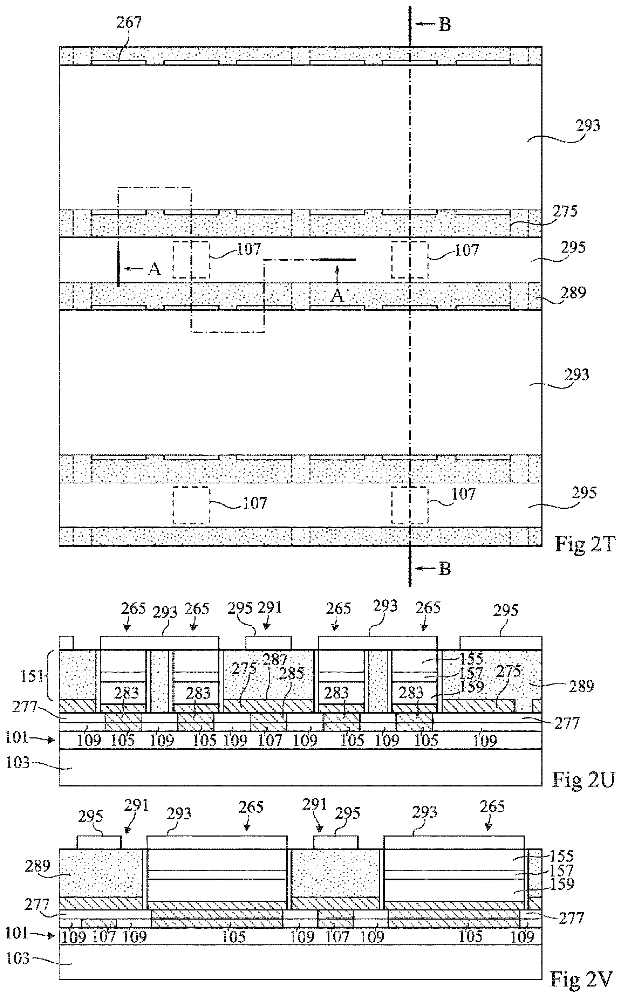

La figure 2T est une vue de dessus illustrant une étape ultérieure de réalisation d'électrodes de cathode communes sur les empilements des LED 265 et des diodes photosensibles 291 du dispositif. Les figures 2U et 2V sont des vues en coupe, selon les plans respectivement AA et BB de la figure 2T, de cette même étape. Dans l'exemple représenté, on forme plus précisément des électrodes de cathode 293 communes à toutes les LED 265 d'une même rangée de LED du dispositif et des électrodes de cathode 295 communes à toutes les diodes photosensibles 291 d'une même rangée de diodes photosensibles du dispositif. Les électrodes de cathode 293 et 295 sont par exemple en un oxyde conducteur transparent, par exemple l'ITO. Les électrodes de cathode communes 293 et 295 sont par exemple réalisées de la même façon que les cathodes communes 177 et 179. À titre de variante, par exemple dans un cas où les LED 265 et les diodes photosensibles 291 du dispositif présentent des tensions de fonctionnement semblables, on peut prévoir une unique électrode de cathode commune à toutes les LED 265 et à toutes les diodes photosensibles 291 du dispositif, le contrôle individuel des LED 265 et des diodes photosensibles 291 s'effectuant par les plots conducteurs 105 et 107, respectivement.

Dans l'exemple représenté, on obtient, à l'issue des étapes décrites en relation avec les figures 2A à 2V, un dispositif combinant des fonctions d'émission lumineuse et de photodétection.

Les procédés décrits respectivement en relation avec les figures 1A à 1T et avec les figures 2A à 2V peuvent être utilisés pour réaliser des micro-écrans monolithiques, combinant une fonction d'affichage d'images et une fonction de capture optique, par exemple pour réaliser un écran interactif adapté à mettre en œuvre des fonctions de reconnaissance faciale ou du regard ("eye tracking", en anglais), de reconnaissance de formes, de détection de mouvement, d'identification, etc. Un avantage des procédés décrits est qu'ils permettent de réaliser des pixels d'affichage et des pixels de capture de petites dimensions latérales, et ainsi obtenir des résolutions d'affichage et des résolutions de capture élevées. On notera que dans l'exemple décrit ci-dessus, le dispositif comprend des macro-pixels comprenant chacun un pixel de détection et trois pixels d'émission adaptés à émettre respectivement dans trois gammes de longueurs d'ondes distinctes. Autrement dit, la résolution du dispositif en émission et la résolution du dispositif en réception sont identiques. À titre de variante, la résolution du dispositif d'affichage et la résolution du capteur optique peuvent être différentes. En particulier, le nombre de pixels de détection peut être inférieur au nombre de pixels d'émission d'une même gamme de longueurs d'ondes. On pourrait en outre prévoir un dispositif comprenant trois pixels d'émission adaptés à émettre dans le visible et au moins un autre pixel d'émission adapté à émettre dans l'infrarouge.

À titre de variante, les procédés décrits respectivement en relation avec les figures 1A à 1T et avec les figures 2A à 2V peuvent être utilisés pour réaliser des dispositifs d'affichage interactifs de plus grandes dimensions, par exemple un écran de télévision, d'ordinateur, de smartphone, de tablette numérique, etc. Un tel dispositif peut comporter une pluralité de puces électroniques élémentaires disposées, par exemple selon un agencement matriciel, sur un même substrat de report. Les puces élémentaires sont montées solidaires du substrat de report et connectées à des éléments de connexion électrique du substrat de report pour leur commande. Chaque puce comporte une ou plusieurs LED 165, 265 une ou plusieurs diodes photosensibles 175, 291, et un circuit 101 de commande de ladite une ou plusieurs LED et de ladite une ou plusieurs diodes photosensibles. Chaque puce correspond par exemple à un macro-pixel du dispositif. À titre d'exemple, chaque puce comprend trois LED commandables individuellement, définissant respectivement trois pixels d'émission adaptés à émettre respectivement de la lumière rouge, de la lumière verte et de la lumière bleue, et une diode photosensible adaptée à détecter un rayonnement infrarouge ou proche infrarouge, définissant un pixel de détection.

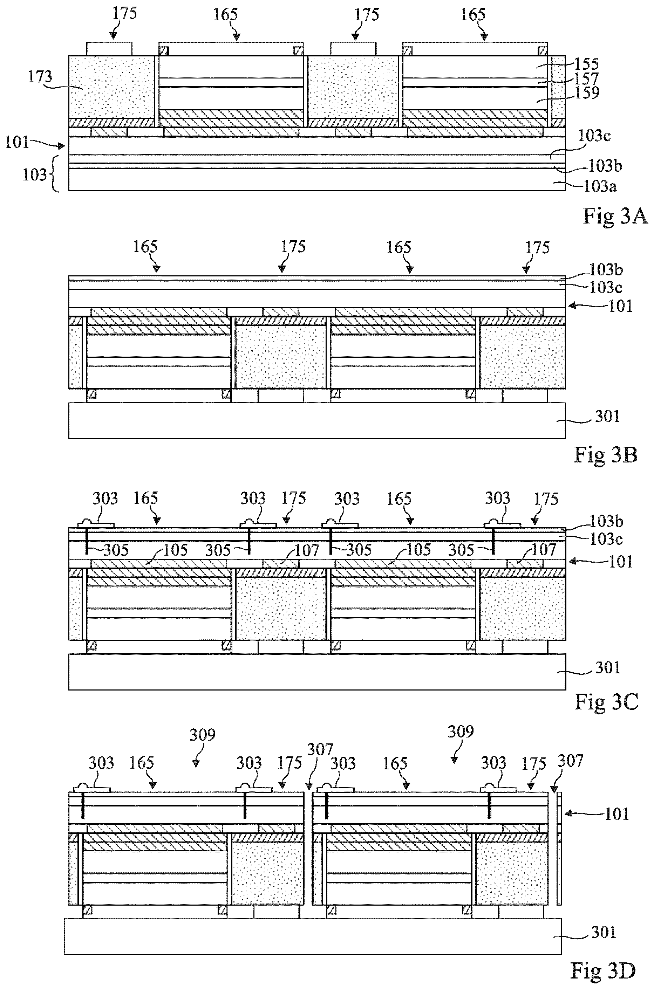

Les figures 3A à 3G sont des vues en coupe illustrant des étapes successives d'un exemple d'un procédé de fabrication d'un tel dispositif.

La figure 3A est une vue en coupe représentant de façon schématique et partielle un dispositif analogue au dispositif précédemment décrit en relation avec la figure 1T. Le dispositif de la figure 3A diffère du dispositif de la figure 1T principalement en ce que le substrat semiconducteur 103 du dispositif de la figure 3A est de type SOI. Dans l'exemple représenté, le substrat 103 du dispositif de la figure 3A comprend un support en silicium 103a revêtu d'une couche isolante 103b elle-même revêtue d'une couche en silicium monocristallin 103c. Par souci de clarté, les couches 103a, 103b et 103c ne sont pas représentées à l'échelle.

La figure 3B illustre une étape de collage de la structure de la figure 3A sur un substrat de support temporaire 301, par exemple en silicium. La structure de la figure 3A est fixée au substrat de support 301 par sa face opposée au circuit intégré de contrôle 101, c'est-à-dire par sa face inférieure dans l'orientation de la figure 3B, correspondant à sa face supérieure dans l'orientation de la figure 3A.

La figure 3B illustre en outre une étape optionnelle d'amincissement du substrat semiconducteur 103, par sa face opposée au circuit intégré de contrôle 101. À titre d'exemple, les composants, notamment des transistors, du circuit intégré 101, peuvent être formés dans et sur la couche de silicium monocristallin 103c du substrat SOI. L'étape d'amincissement de la figure 3B peut consister, comme illustré sur cette figure, à retirer le substrat de support 103a du substrat SOI 103, de façon à ne conserver que la couche de silicium monocristallin 103c et la couche isolante 103b du substrat SOI.

À titre de variante, dans un cas où le circuit intégré 101 est formé dans et sur un substrat massif de silicium, l'étape d'amincissement peut consister à réduire l'épaisseur du substrat, par exemple par meulage, à partir de sa face supérieure (dans l'orientation de la figure 3B). Une couche isolante de passivation (non détaillée sur la figure) peut ensuite être déposée sur la face supérieure du substrat aminci.

La figure 3C illustre des étapes ultérieures de formation, du côté de la face supérieure du circuit intégré 101, de plots métalliques de connexion 303, reliés aux plots de connexion 105, 107 et/ou à des bornes de connexion de composants électroniques, par exemple des transistors MOS, du circuit intégré 101, par l'intermédiaire de vias conducteurs 305 traversant le substrat semiconducteur 103 du circuit intégré 101. Chaque via conducteur 305 contacte par exemple un niveau de connexion du circuit intégré de contrôle 101.

La figure 3D illustre une étape de formation, à partir de la face supérieure du circuit intégré 101, de tranchées 307 traversant verticalement le circuit intégré 101 et la structure dans laquelle sont formées les LED et les diodes photosensibles, et débouchant sur la face supérieure du substrat de support temporaire 301. Les tranchées 307 délimitent latéralement une pluralité de puces semiconductrices 309 correspondant aux puces élémentaires de pixel du dispositif d'affichage. Les tranchées 307 peuvent être formées par gravure plasma, par sciage, ou par toute autre méthode de découpe adaptée.

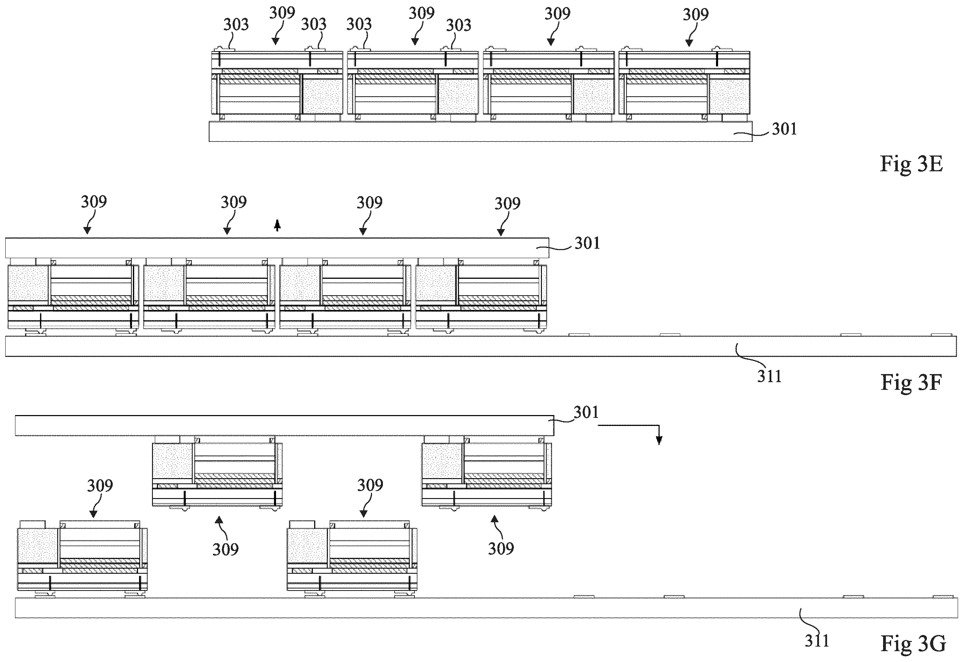

La figure 3E illustre une partie du support temporaire 301 sur lequel sont fixées les puces semiconductrices 309. Dans l'exemple représenté, quatre puces semiconductrices 309 sont fixées en surface du support temporaire 301 étant entendu que, en pratique, un nombre plus important de puces semiconductrices 309 peuvent être fixées sur le support 301.

Les figures 3F et 3G illustrent une étape de fixation de puces élémentaires 309 sur la face supérieure d'un même substrat de report 311 du dispositif d'affichage. Le substrat de report 311 comprend, du côté de sa face supérieure, une pluralité de plots métalliques de connexion 313, destinés à être fixés et connectés électriquement et mécaniquement à des plots de connexion métalliques correspondants 303 des puces élémentaires 309.

La structure de la figure 3E est retournée de façon à placer les plots de connexion métalliques 303 de puces élémentaires 309 en vis-à-vis de plots de connexion métalliques 313 correspondants du substrat de report 311. Les plots 303 et 313 en vis-à-vis sont ensuite fixés et connectés électriquement, par exemple par collage direct, par soudure, au moyen de microtubes, ou par toute autre méthode adaptée.

Une fois fixées au substrat de report 311 (figure 3F), les puces élémentaires 309 sont détachées du substrat de support temporaire 301, et ce dernier est retiré (figure 3G). À titre d'exemple, le détachage des puces 309 est réalisé par décollement mécanique ou par décollement au moyen d'un faisceau laser.

Dans l'exemple représenté, le pas (distance centre à centre en vue de face) des puces élémentaires 309 sur le substrat de report 311 est un multiple du pas des puces élémentaires 309 sur le substrat de support temporaire 301. Ainsi, seule une partie des puces élémentaires 309 (une sur deux, dans l'exemple représenté) sont transférées simultanément du substrat de support temporaire 301 sur le substrat de report 311. Les autres puces restent attachées au substrat de support temporaire 301. Ces puces restantes peuvent ensuite être reportées sur une autre partie du substrat de report 311. À titre de variante, le report de ces puces élémentaires restantes peut s'effectuer sur un autre substrat de report.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et/ou de dimensions mentionnés dans la présente description.

Enfin, la mise en œuvre pratique des modes de réalisation et variantes décrits est à la portée de la personne du métier à partir des indications fonctionnelles données ci-dessus. En particulier, la mise en œuvre du procédé décrit en relation avec les figures 3A à 3G en partant de la structure obtenue à l'issue du procédé décrit en relation avec les figures 2A à 2V est à la portée de la personne du métier à partir des indications de la présente description.

L'invention est définie par les revendications annexées.

## Revendications

1. Procédé de fabrication d'un dispositif optoélectronique comprenant les étapes successives suivantes :
a) former, sur un circuit intégré de contrôle (101) préalablement formé dans et sur un substrat semiconducteur (103), une pluralité de diodes électroluminescentes inorganiques (165 ; 265) ; et
b) déposer une couche active semiconductrice de photodétection (173 ; 289) de sorte à remplir totalement tous les espaces libres s'étendant latéralement entre les diodes électroluminescentes inorganiques (165 ; 265).

2. Procédé selon la revendication 1, comprenant la formation d'une pluralité de diodes photosensibles (175 ; 291) dans la couche active semiconductrice de photodétection (173 ; 289).

3. Procédé selon la revendication 2, comprenant, après l'étape a) et avant l'étape b), une étape de formation d'électrodes (171 ; 287) des diodes photosensibles (175 ; 291) entre les diodes électroluminescentes inorganiques (165 ; 265).

4. Procédé selon l'une quelconque des revendications 1 à 3, dans lequel la couche active semiconductrice de photodétection (173 ; 289) comprend au moins un matériau polymère.

5. Procédé selon l'une quelconque des revendications 1 à 4, dans lequel la couche active semiconductrice de photodétection (173 ; 289) comprend des boîtes quantiques.

6. Procédé selon l'une quelconque des revendications 1 à 5, dans lequel la couche active semiconductrice de photodétection (173 ; 289) est une couche semiconductrice organique.

7. Procédé selon l'une quelconque des revendications 1 à 6, dans lequel la couche active semiconductrice de photodétection (173 ; 289) est déposée par voie liquide entre les diodes électroluminescentes inorganiques (165 ; 265).

8. Procédé selon l'une quelconque des revendications 1 à 7, dans lequel l'étape a) comprend une étape de report d'un empilement actif de diode électroluminescente inorganique (151) sur le circuit intégré de contrôle (101), puis une étape de gravure de tranchées dans l'empilement actif de diode électroluminescente inorganique (151), de façon à séparer latéralement les diodes électroluminescentes inorganiques (165) les unes des autres.

9. Procédé selon la revendication 8, comprenant en outre, après l'étape a) et avant l'étape b), une étape de dépôt anisotrope d'une couche conductrice (169) sur et entre les diodes électroluminescentes inorganiques (165).

10. Procédé selon l'une quelconque des revendications 1 à 7, dans lequel l'étape a) comprend une étape de report, sur le circuit intégré de contrôle, d'une structure comprenant, sur un substrat de support (153), les diodes électroluminescentes inorganiques (265), et, entre les diodes électroluminescentes inorganiques (265), un empilement (269) comprenant, depuis le substrat de support (153), une première couche conductrice (271), une couche isolante (273) et une deuxième couche conductrice (275), la deuxième couche conductrice (275) affleurant une face des diodes électroluminescentes inorganiques (265) opposée au substrat de support.

11. Procédé selon la revendication 10, comprenant en outre, après l'étape de report, une étape de retrait du substrat de support (153) puis une étape de gravure de la deuxième couche conductrice (275), dans laquelle la couche isolante (273) sert de couche d'arrêt de gravure.

12. Procédé selon l'une quelconque des revendications 1 à 11, comportant, après l'étape b), une étape de fixation d'un substrat de support temporaire (301) du côté d'une face du dispositif opposée au circuit intégré (101), suivie d'une étape de découpe de l'ensemble comportant le circuit intégré (101), la couche active semiconductrice de photodétection (173 ; 289) et les diodes électroluminescentes inorganiques (165 ; 265) en une pluralité de puces élémentaires (309).

13. Procédé selon la revendication 12, comportant en outre une étape de transfert et de fixation desdites puces élémentaires (309) sur un substrat de report (311) du dispositif, puis une étape de retrait du substrat de support temporaire (301).

14. Dispositif optoélectronique comportant :
- un circuit intégré de contrôle (101) formé dans et sur un substrat semiconducteur (103) ;
- une pluralité de diodes électroluminescentes inorganiques (165 ; 265) disposées sur une face du circuit intégré de contrôle (101) ; et
- une couche active semiconductrice organique de photodétection (173 ; 289) remplissant totalement tous les espaces libres s'étendant latéralement entre les diodes électroluminescentes (165 ; 265).

15. Dispositif optoélectronique comportant un substrat de report (311), et une pluralité de puces élémentaires (309) fixées et connectées électriquement au substrat de report (311), chaque puce élémentaire (309) comprenant un dispositif selon la revendication 14, le circuit intégré de contrôle (101) étant disposé du côté du substrat de report (311).

## Patentansprüche

1. Verfahren zur Herstellung einer optoelektronischen Vorrichtung, das die folgenden aufeinanderfolgenden Schritte aufweist:
a) Bilden einer Vielzahl von anorganischen Licht emittierenden Dioden (165; 265) auf einer integrierten Steuerschaltung (101), die zuvor innerhalb und auf einem Halbleitersubstrat (103) gebildet wurde; und
b) Abscheiden einer aktiven photodetektierenden Halbleiterschicht (173; 289), um all die freien Räume, die sich seitlich zwischen den anorganischen Licht emittierenden Dioden (165; 265) erstrecken, vollständig auszufüllen.

2. Verfahren nach Anspruch 1, das das Ausbilden einer Vielzahl von lichtempfindlichen Dioden (175; 291) in der aktiven photodetektierenden Halbleiterschicht (173; 289) aufweist.

3. Verfahren nach Anspruch 2, das, und zwar nach Schritt a) und vor Schritt b), einen Schritt zum Ausbilden von Elektroden (171; 287) der lichtempfindlichen Dioden (175; 291) zwischen den anorganischen Licht emittierenden Dioden (165; 265) aufweist.

4. Verfahren nach einem der Ansprüche 1 bis 3, wobei die aktive photodetektierende Halbleiterschicht (173; 289) mindestens ein Polymermaterial aufweist.

5. Verfahren nach einem der Ansprüche 1 bis 4, wobei die aktive photodetektierende Halbleiterschicht (173; 289) Quantenpunkte aufweist.

6. Verfahren nach einem der Ansprüche 1 bis 5, wobei die aktive photodetektierende Halbleiterschicht (173; 289) eine organische Halbleiterschicht ist.

7. Verfahren nach einem der Ansprüche 1 bis 6, wobei die aktive photodetektierenden Halbleiterschicht (173; 289) durch Flüssigkeitsabscheidung zwischen den anorganischen Licht emittierenden Dioden (165; 265) abgeschieden wird.

8. Verfahren nach einem der Ansprüche 1 bis 7, wobei Schritt a) einen Schritt des Übertragens eines Stapels (151) von aktiven anorganischen Licht emittierenden Dioden auf die integrierte Steuerschaltung (101) aufweist, und anschließend einen Schritt des Ätzens von Gräben in den Stapel (151) von aktiven anorganischen Licht emittierenden Dioden, um die anorganischen Licht emittierenden Dioden (165) seitlich voneinander zu trennen.

9. Verfahren nach Anspruch 8, das, und zwar nach Schritt a) und vor Schritt b), einen Schritt des anisotropen Abscheidens einer leitfähigen Schicht (169) auf und zwischen den anorganischen Licht emittierenden Dioden (165) aufweist.

10. Verfahren nach einem der Ansprüche 1 bis 9, wobei Schritt a) einen Schritt des Übertragens einer Struktur auf die integrierte Steuerschaltung aufweist, die auf einem Trägersubstrat (153) die anorganischen Licht emittierenden Dioden (265) und zwischen den anorganischen Licht emittierenden Dioden (265) einen Stapel (269) aufweist, der vom Trägersubstrat (153) aus eine erste leitfähige Schicht (271), eine Isolierschicht (273) und eine zweite leitfähige Schicht (275) aufweist, wobei die zweite leitfähige Schicht (275) bündig mit einer Oberfläche der anorganischen Licht emittierenden Dioden (265) gegenüber dem Trägersubstrat ist.

11. Verfahren nach Anspruch 10, das nach dem Übertragungsschritt ferner einen Schritt zum Entfernen des Trägersubstrats (153) und dann einen Schritt zum Ätzen der zweiten leitfähigen Schicht (275) aufweist, wobei die Isolierschicht (273) als Ätzstoppschicht verwendet wird.

12. Verfahren nach einem der Ansprüche 1 bis 11, das, und zwar nach Schritt b), einen Schritt des Aufbringens eines temporären Trägersubstrats (301) aufweist, und zwar auf die dem integrierten Schaltkreis (101) gegenüberliegende Seite einer Oberfläche der Vorrichtung, gefolgt von einem Schritt des Schneidens der Anordnung, die den integrierten Schaltkreis (101), die aktive photodetektierenden Halbleiterschicht (173; 289) und die anorganischen Licht emittierenden Dioden (165; 265) in eine Vielzahl von Elementarchips (309) aufweist.

13. Verfahren nach Anspruch 12, das ferner einen Schritt des Übertragens und Bondens der Elementarchips (309) auf ein Übertragungssubstrat (311) der Vorrichtung und dann einen Schritt des Entfernens des temporären Trägersubstrats (301) aufweist.

14. Optoelektronische Vorrichtung, aufweisend:
- eine integrierte Steuerschaltung (101), die innerhalb und auf einem Halbleitersubstrat (103) ausgebildet ist;
- eine Vielzahl von anorganischen Licht emittierenden Dioden (165; 265), die auf einer Oberfläche der integrierten Steuerschaltung (101) angeordnet sind; und
- eine aktive photodetektierende organische Halbleiterschicht (173; 289), die alle freien Räume, die sich seitlich zwischen den Licht emittierenden Dioden (165; 265) erstrecken, vollständig ausfüllt.

15. Optoelektronische Vorrichtung, aufweisend ein Transfersubstrat (311) und eine Vielzahl von Elementarchips (309), die mit dem Transfersubstrat (311) verbunden und elektrisch mit diesem gebondet sind, wobei jeder Elementarchip (309) eine Vorrichtung gemäß Anspruch 14 aufweist, wobei die integrierte Steuerschaltung (101) auf der Seite des Transfersubstrats (311) angeordnet ist.

## Claims

1. Optoelectronic device manufacturing method comprising the successive steps of:
a) forming, on an integrated control circuit (101) previously formed inside and on top of a semiconductor substrate (103), a plurality of inorganic light-emitting diodes (165; 265); and
b) depositing an active photodetection semiconductor layer (173; 289) to totally fill all the free spaces laterally extending between the inorganic light-emitting diodes (165; 265).

2. Method according to claim 1, comprising the forming of a plurality of photosensitive diodes (175; 291) in the active photodetection semiconductor layer (173; 289).

3. Method according to claim 2, comprising, after step a) and before step b), a step of forming of electrodes (171; 287) of the photosensitive diodes (175; 291) between the inorganic light-emitting diodes (165; 265).

4. Method according to any one of claims 1 to 3, wherein the active photodetection semiconductor layer (173; 289) comprises at least one polymer material.

5. Method according to any one of claims 1 to 4, wherein the active photodetection semiconductor layer (173; 289) comprises quantum dots.

6. Method according to any one of claims 1 to 5, wherein the active photodetection semiconductor layer (173; 289) is an organic semiconductor layer.

7. Method according to any one of claims 1 to 6, wherein the active photodetection semiconductor layer (173; 289) is deposited by liquid deposition between the inorganic light-emitting diodes (165; 265).

8. Method according to any one of claims 1 to 7, wherein step a) comprises a step of transfer of an active inorganic light-emitting diode stack (151) onto the integrated control circuit (101), and then a step of etching of trenches in the active inorganic light-emitting diode stack (151), in order to laterally separate the inorganic light-emitting diodes (165) from one another.

9. Method according to claim 8, further comprising, after step a) and before step b), a step of anisotropic deposition of a conductive layer (169) on top of and between the inorganic light-emitting diodes (165).

10. Method according to any one of claims 1 to 9, wherein step a) comprises a step of transfer, onto the integrated control circuit, of a structure comprising, on a support substrate (153), the inorganic light-emitting diodes (265) and, between the inorganic light-emitting diodes (265), a stack (269) comprising, from the support substrate (153), a first conductive layer (271), an insulating layer (273), and a second conductive layer (275), the second conductive layer (275) being flush with a surface of the inorganic light-emitting diodes (265) opposite to the support substrate.

11. Method according to claim 10, further comprising, after the transfer step, a step of removal of the support substrate (153) and then a step of etching of the second conductive layer (275), wherein the insulating layer (273) is used as an etch stop layer.

12. Method according to any one of claims 1 to 11, comprising, after step b), a step of bonding of a temporary support substrate (301) on the side of a surface of the device opposite to the integrated circuit (101), followed by a step of cutting of the assembly comprising the integrated circuit (101), the active photodetection semiconductor layer (173; 289), and the inorganic light-emitting diodes (165; 265) into a plurality of elementary chips (309).

13. Method according to claim 12, further comprising a step of transfer and of bonding of said elementary chips (309) onto a transfer substrate (311) of the device, and then a step of removal of the temporary support substrate (301).

14. Optoelectronic device comprising:
- an integrated control circuit (101) formed inside and on top of a semiconductor substrate (103);
- a plurality of inorganic light-emitting diodes (165; 265) arranged on a surface of the integrated control circuit (101); and
- an active photodetection semiconductor organic layer (173; 289) totally filling all the free spaces laterally extending between the light-emitting diodes (165; 265).

15. Optoelectronic device comprising a transfer substrate (311) and a plurality of elementary chips (309) bonded and electrically connected to the transfer substrate (311), each elementary chip (309) comprising a device according to claim 14, the integrated control circuit (101) being arranged on the side of the transfer substrate (311).
